**Europäisches Patentamt**

**European Patent Office**

**Office européen des brevets**

(19)

(11) Veröffentlichungsnummer: **0 156 007**
**B1**

(12) **EUROPÄISCHE PATENTSCHRIFT**

(45) Veröffentlichungstag der Patentschrift:
08.03.89

(21) Anmeldenummer: **84114712.7**

(22) Anmeldetag: **04.12.84**

(51) Int. Cl.⁴: **H 01 J 37/147,** H 01 J 37/18,
H 01 J 37/28

(54) Korpuskelbeschleunigende Elektrode.

(30) Priorität: **27.02.84 DE 3407050**

(43) Veröffentlichungstag der Anmeldung:
**02.10.85 Patentblatt 85/40**

(45) Bekanntmachung des Hinweises auf die Patenterteilung:
**08.03.89 Patentblatt 89/10**

(84) Benannte Vertragsstaaten:
**DE FR GB IT NL**

(56) Entgegenhaltungen:
EP-A-0 001 228
DE-A-2 243 616

(73) Patentinhaber: **Siemens Aktiengesellschaft Berlin
und München, Wittelsbacherplatz 2, D-8000
München 2 (DE)**

(72) Erfinder: **Feuerbaum, Hans-Peter, Dr.- Ing., Dipl.-
Phys., Arno- Assmann- Strasse 14, D-8000
München 83 (DE)**

EP 0 156 007 B1

LIBER, STOCKHOLM 1989

## Beschreibung

Die Erfindung betrifft eine korpuskelbeschleunigende Elektrode nach dem Oberbegriff des Anspruchs 1.

In der Elektronenstrahl-Meßtechnik ist es üblich, hochfrequente Vorgänge an einem Meßpunkt mit Hilfe von stroboskopischen Meßverfahren aufzuzeichnen. Bei einem stroboskopischen Meßverfahren wird synchron mit dem hochfrequenten Vorgang an einem Meßpunkt ein Elektronenstrahl oder - allgemeiner gesprochen - ein Korpuskularstrahl so eingetastet, daß während einer jeden Periode des hochfrequenten Vorgangs an dem Meßpunkt der Korpuskularstrahl nur während eines Bruchteils oder während mehrerer Bruchteile der Periodendauer dieses hochfrequenten Vorgangs den Meßpunkt abtastet und dabei Meßsignale auslöst. Vorzugsweise verden stroboskopische Meßverfahren in Raster-Elektronenmikroskopen durchgeführt. Weil bei Stroboskopischen Meßverfahren der Korpuskularstrahl ein- und ausgetastet verden können muß, wird in einem stroboskopischen Meßgerät ein Korpuskularstrahl-Austastsystem benötigt. Ein solches Korpuskularstrahl-Austastsystem ist üblicherweise als Teil eines Strahlerzeugungssystems angeordnet.

Aus der europäischen Patentanmeldung EP-A-0 001 228 ist ein Austastsystem für einen Korpuskularstrahl bekannt, bei dem der Korpuskularstrahl nach seiner Emission mit Hilfe einer Wehnelt-Elektrode geformt wird und sodann eine als Lochscheibe ausgebildete Beschleunigungselektrode passiert. Nach Durchgang durch diese Beschleunigungselektrode trifft der Korpuskularstrahl auf eine erste Lochblende, passiert sodann das eigentliche Ablenksystem, welches zwei symmetrische Ablenkplatten aufweist, tritt erneut durch eine weitere Lochblende hindurch, um schließlich durch eine dritte Lochscheibe hindurch, welche auf einem Vakuumrohr befestigt ist, in dieses Vakuumrohr einzutreten. Da diese bekannte Vorrichtung zur Austastung eines Korpuskularstrahls in Richtung des Korpuskularstrahls sehr ausgedehnt ist, erfordert der Einbau eines solchen Austastsystems in ein Korpuskularstrahlgerät eine Verlängerung der korpuskularoptischen Säule durch Einbringen eines zusätzlichen Ringes in diese korpuskularoptische Säule. Eine solche Vorrichtung ist überdies schwer handhabbar, weil beim Austausch einer solchen Anordnung oder auch beim bloßen Herausnehmen einer solchen Anordnung aus der korpuskularoptischen Säule viele verschiedene einzelne Teile jeweils für sich abmontiert werden müssen. Überdies werden wegen der vielen verschieden Einzelteile aufwendige Justiersysteme benötigt, die die gesamte Vorrichtung relativ teuer machen. Die gesamte Anordnung erfordert außerdem viele einzelne Lochblenden bzw. Lochscheiben, um einerseits korpuskeloptischen Erfordernissen zu genügen und um andererseits eine gute Vakuum-Aufrechterhaltung zu ermöglichen. Das gesamte Austastsystem ist bei dieser bekannten Vorrichtung zusammen mit dem Strahlerzeuger in einem vakuumdichten Gehäuse untergebracht.

Aus der DE-Patentanmeldung P-3 204 897.1 ist ein korpuskularstrahlerzeugendes System bekannt, welches eine korpuskelbeschleunigende Elektrode aufweist, die als Faraday-Käfig ausgebildet ist und in deren Innerem ein Austastsystem zur Austastung eines Korpuskularstrahls angebracht ist. Dieses bekannte korpuskularstrahlerzeugende System ist so ausgebildet, daß es einen optimalen Richtstrahlwert und eine optimale Zentrierung für eine bestimmte Beschleunigungsspannung ermöglicht. Da in der genannten Patentanmeldung über eine erforderliche Vakuum-Aufrechterhaltung des korpuskularstrahlerzeugenden Systems nichts ausgesagt ist, wird davon ausgegangen, daß auch diese korpuskelbeschleunigende Elektrode zusammen mit dem Austastsystem in einer nach dem Stand der Technik üblichen Weise in den korpuskularoptischen Strahlengang eingebracht wird. Weil die korpuskelemittierende Elektrode wegen des Austastsystems in Richtung des Korpuskular strahls eine relativ große Ausdehnung aufweist, muß die korpuskularoptische Säule gegenüber einem Korpuskular strahlsystem ohne Austastsystem verlängert werden, was üblicherweise durch zusätzliches Einbringen eines Ringes in die korpuskularoptische Säule erfolgt. Überdies sind ebenso wie bei der obengenannten Vorrichtung zur Vakuum-Aufrechterhaltung zusätzliche Lochscheiben bzw. Lochblenden erforderlich, die einen erheblichen Aufwand an zusätzlichen Justiermaßnahmen mit sich bringen.

Der vorliegenden Erfindung liegt die Aufgabe zugrunde, eine korpuskelbeschleunigende Elektrode der eingangs genannten Art anzugeben, die das Problem der Aufrechterhaltung des Kathodenraumvakuums in einfacher Weise löst, bei der die korpuskularoptische Säule nicht verlängert werden muß, die einfach handbar und kostengünstig herzustellen ist.

Diese Aufgabe wird erfindungsgemäß durch eine korpuskelbe schleunigende Elektrode nach dem Anspruch 1 gelöst.

Ausgestaltungen und Vorteile der Erfindung sind in den Unteransprüchen, der Beschreibung und der Zeichnung dargestellt.

Eine korpuskelbeschleunigende Elektrode nach der Erfindung ermöglicht eine einfache Justierung im korpuskularoptischen Strahlengang. Ein Stutzen einer erfindungsgemäßen Elektrode kann so ausgebildet sein, daß er als Flansch in eine Öffnung einer Vakuumwand einpaßbar ist. Wenn diese Öffnung bezüglich der korpuskularoptischen Achse in definierter Weise angeordnet ist, dann ist über eine definierte Anordnung des Stutzens an der korpuskelbeschleunigenden Elektrode auch diese Elektrode in definierter Weise bezüglich der korpuskularoptischen Achse angeordnet.

Der Stutzen der korpuskelbeschleunigenden Elektrode kann so ausgebildet sein, daß auf ihm ein zusätzlicher Flanschring angeordnet werden kann, der flexibel an verschiedene Öffnungen von Vakuumwänden von verschiedenen kommerziell erhältlichen Korpuskularstrahlgeräten anpaßbar ist.

Als Blende zur Aufrechterhaltung des Vakuums im Kathodenraum (im folgenden kurz Blende genannt) kann insbesondere eine Lochblende oder eine Lochscheibe in die korpuskelbeschleunigende Elektrode integriert werden. Vorteilhafterweise soll die Bohrung der korpuskelbeschleunigenden Elektrode an deren Korpuskularstrahl-Eingang so ausgebildet sein, daß sie einen optimalen Richtstrahl und eine optimale Zentrierung des Korpuskularstrahles ermöglicht. Zu diesem Zweck ist es günstig, wenn die Blende erst am Ende dieser Bohrung unmittelbar vor dem Austastsystem angeordnet ist. Diese Blende muß hierbei nicht als gesondertes Teil ausgebildet sein. Auch die Bohrung am Korpuskularstrahl-Eingang der korpuskelbeschleunigenden Elektrode kann so ausgebildet sein, daß sie sich allmählich, stufenweise oder abrupt auf die zur Aufrechterhaltung des Kathodenraumvakuums erforderlichen Abmessungen verringert.

Die Blende kann auch am Korpuskularstrahl-Ausgang der korpuskelbeschleunigenden Elektrode angeordnet sein. Grundsätzlich genügt es, nur eine einzige Blende in die korpuskelbeschleunigende Elektrode zu integrieren. Diese kann dann an einer beliebigen Stelle der korpuskelbeschleunigenden Elektrode angeordnet sein, sofern sie nur den Zweck der Aufrechterhaltung des Kathodenraumvakuums erfüllt.

In der Elektronenstrahl-Meßtechnik wird bei der quantitativen Potentialmessung an hochintegrierten elektronischen Bauelementen üblicherweise mit einer Beschleunigungsspannung von 2,5 kV gearbeitet. Da bei einer Hochstromquelle die Potentialauflösung besonders günstig ist, werden vorteilhafterweise Hochstrom-Kathoden, wie beispielsweise Lanthanhexaborid-Kathoden, verwendet. Solche Hochstrom-Kathoden erfordern jedoch ein besonders gutes Vakuum im Kathodenraum, weil sonst die Leistungsfähigkeit dieser Hochstrom-Kathoden leidet. In einem solchen Fall ist es günstig, wenn am Korpuskularstrahl-Eingang der korpuskelbeschleunigenden Elektrode beispielsweise eine Lochblende oder eine Lochscheibe mit einer besonders kleinen Öffnung vorgesehen ist. In einem solchen Fall ist es zur Aufrechterhaltung des Kathodenraumvakuums und zur Strahlformung besonders günstig, wenn am Korpuskularstrahl-Ausgang der korpuskelbeschleunigenden Elektrode eine weitere Blende, beispielsweise eine Lochblende mit einer kleinen Öffnung, vorgesehen ist. Da das Vakuum in der korpuskularoptischen Säule in Höhe der Abbildungseinrichtungen bzw. Ablenkeinrichtungen weniger gut sein muß, kann die Öffnung der Lochblende am Korpuskularstrahl-Ausgang der korpuskelbeschleunigenden Elektrode etwas größer sein als die Öffnung der Lochblende am Korpuskularstrahl-Eingang.

Bei einer erfindungsgemäßen Vorrichtung ist die korpuskelbeschleunigende Elektrode mit dem Austastsystem und wenigstens einer Blende zur Aufrechterhaltung des Kathodenraumvakuums kompakt austauschbar. Die Erfindung ermöglicht es, daß eine korpuskularoptische Säule eines Korpuskularstrahl-Gerätes ohne Verlängerungsring verwendet werden kann. Die Erfindung erleichtert die Justierung der korpuskelbeschleunigenden Elektrode. Die Erfindung löst das Vakuum-Problem - insgesamt gesehen besser - als nach dem Stand der Technik möglich, weil weniger Teile im Strahlengang justiert werden müssen und somit engere Toleranzen bei Blenden zur Aufrechterhaltung des Kathodenraumvakuums möglich sind. Beim Wechsel zwischen verschiedenen Beschleunigungsspannungen kann eine erfindungsgemäße Elektrode relativ bequem gegen eine andere Elektrode ausgetauscht werden, ohne daß die Kathode oder die Anode in ihrer Position verändert werden müssen.

Die Erfindung wird im folgenden anhand der Zeichnungen näher erläutert.

Hierbei zeigt:

Fig. 1   den schematischen Aufbau eines Korpuskularstrahl Gerätes mit einer erfindungsgemäßen korpuskelbeschleunigenden Elektrode.

Fig. 2   eine korpuskelbeschleunigende Elektrode nach der Erfindung.

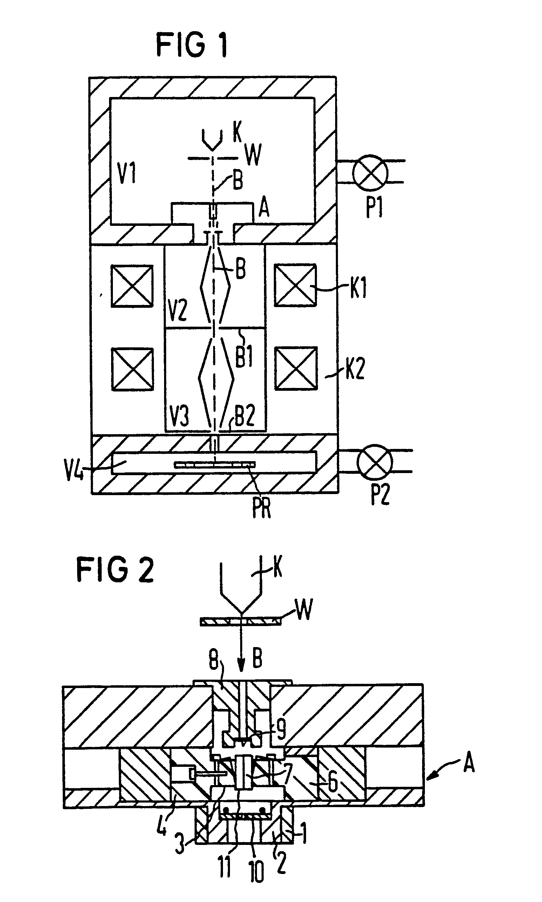

Fig. 1 zeigt schematisch eine Elektronenstrahl-Gerät. Im Kathodenraum wird von der Kathode K ein Elektronenstrahl B emittiert und von einer Wehnelt-Elektrode W geformt. Der Elektronenstrahl B wird in Richtung zu einer erfindungsge mäßen elektronenstrahlbeschleunigenden Anode A hin beschleunigt. Der Elektronenstrahl B passiert zunächst eine Bohrung in der Anode A, die für eine Beschleunigungsspannung von 2,5 kV optimal ausgebildet ist. Am Ende dieser Bohrung tritt der Elektronenstrahl B durch eine Blende hindurch, die das Vakuum V1 des Kathodenraumes gegen die restlichen Vakua des Elektronenstrahl-Gerätes aufrechterhält. Das Vakuum V1 des Kathodenraumes wird über eine Pumpe P 1 erzeugt.

Nach Durchtritt durch die erste Blende der Anode A passiert der Elektronenstrahl B zwei Platten eines Austastsystems, tritt sodann durch eine weitere Blende hindurch und gelangt sodann in den ersten Teil V2 eines Vakuumrohres. Nach Passieren eines ersten Blendenschiebers B1 mit einer Abmessung der Öffnung von etwa 300 μm passiert der Elektronenstrahl B den zweiten Teil V3 des Vakuumrohres und tritt durch einen weiteren Blendenschieber B2 hindurch. Schließlich trifft der Elektronenstrahl B auf einen Meßpunkt der Probe PR. Diese Probe PR befindet sich in einem Vakuum V4. Dieses Vakuum V4 wird über eine Pumpe P2 erzeugt. Im Vakuumrohr mit den Teilen V2, V3 wird der Elektronenstrahl B durch die Kondensorlinsen K1, K2 und durch weitere Ablenkeinrichtungen, die in der Zeichnung nicht dargestellt sind, beeinflußt.

Fig. 2 zeigt schematisch eine erfindungsgemäße elektronenbeschleunigende Anode A. Der von der Kathode K emittierte Elektronenstrahl B wird von der Wehnelt-Elektrode W geformt. Der Elektronenstrahl B passiert sodann einen ersten Teil 8 am Eingang der Anode A, in Strahlrichtung gesehen. Dieser Teil 8 weist eine Bohrung auf, die einen optimalen Richtstrahlwert und eine optimale Zentrierung ermöglicht. Am Ende dieser Bohrung des Teiles 8 ist eine Blende 9 zur Vakuum-Aufrechterhaltung zwischen dem Vakuum V1 des Kathodenraumes und dem daran anschließenden Teil V2 des Vakuumrohres angeordnet. Die Blende 9 weist einen Durchmesser von 300 μm auf. Dies ermöglicht ein Vakuum V1 im Kathodenraum von $10^{-7}$ bar.

Nach Durchtritt durch die Blende 9 passiert der Elektronenstrahl B die beiden Platten 7, 11 des in den Faraday-Käfig der Anode A integrierten Austastsystems. Damit der Pulsgenerator, der die Austastimpulse für das Austastsystem liefert, möglichst einfach ausgebildet sein kann, liegt vorteilhafterweise die Platte 7 ebenso wie der Teil 8 und die Blende 9 auf Anodenpotential. In einem solchen Fall müssen Austastimpulse von einem Pulsgenerator nur an die Platte 11 übermittelt werden. Diese Platte 11 muß daher elektrisch isoliert sein gegenüber sämtlichen Teilen, die auf Anodenpotential liegen. Vorteilhafterweise ist daher ein Träger 4, an dem über ein Teil 3 die Platte 11 mittels Schrauben befestigt ist, als Isolator ausgebildet. Eine elektrische Leitung für die Austastimpulse für die Platte 11 kann über das Teil 4 und sodann durch eine Bohrung durch ein Teil oder durch mehrere Teile der Anode A hindurchgeführt verden.

Schließlich trifft der Elektronenstrahl B am Elektronenstrahl Ausgang der Anode A auf eine Blende 10. Diese Blende 10 weist einen Durchmesser von 500 μm bis zu 1 mm auf. Der Durchmesser der Blende 10 stellt einen Kompromiß dar, weil er einerseits möglichst klein sein soll, um ein möglichst gutes Vakuum im Teil V2 des Vakuumrohres zu ermöglichen, und weil er andererseits eine gewisse Divergenz des Elektronenstrahls B ermöglichen soll, damit dieser Elektronenstrahl B von den Kondensorlinsen K1, K2 in günstiger Weise geformt werden kann.

Die Anode A weist schließlich noch einen Stutzen 2 auf, der zur Zentrierung und Justierung der Anode A in der Öffnung einer Vakuumwand und zugleich zur Vakuum-Abdichtung dient. Auf diesem Stutzen 2 kann ein Ring 1 angeordnet sein, dessen Abmessungen flexibel an verschiedene Abmessungen von Öffnungen in Vakuumwänden verschiedener kommerziell erhältlicher Elektronenstrahl-Geräte angepaßt werden können. Der Stutzen 2 und die Blende 10 liegen vorteilhafterweise wiederum auf Anodenpotential, ebenso wie die in Fig. 2 nicht mit Ziffern bezeichneten Teile der Anode A, die jedoch ebenfalls wenigstens teilweise auf Anodenpotential zu bringen sind, damit ein Faraday-Käfig ausgebildet sein kann.

Bei Verwendung eines etwas teureren Pulsgenerators können auch beide Ablenkplatten 7, 11 mit Austastimpulsen angesteuert werden. Verfahren zur Ansteuerung von einer Platte oder von zwei einander gegenüberliegenden Platten zur Austastung eines Korpuskularstrahles sind in der US-PS-4 413 181 beschrieben.

Das Vakuum im Teil V2 des Vakuumrohres beträgt etwa $10^{-3}$ bis $10^{-5}$ bar. Das Vakuum V4 beträgt $10^{-5}$ bis 10 bar. Die Höhe der Anode A beträgt etwa 3 cm.

Die Erfindung ermöglicht verbesserte Eigenschaften des Korpuskularstrahls bezüglich seiner Fokussierung.

**Patentansprüche**

1. Korpuskelbeschleunigende Elektrode (A) mit einem innerhalb der als Faraday-Käfig ausgebildeten Elektrode (A) angeordneten Austastsystem (7, 11) zur Austastung eines von einer in einem Gehäuse angeordneten Quelle (K) ausgehenden Korpuskularstrahls (B), gekennzeichnet durch mindestens eine im Strahlengang als Teil der korpuskelbeschleunigenden Elektrode (A) angeordnete Blende, deren Öffnung allmählich oder stufenweise oder abrupt auf Abmessungen verjüngt ist, die zur Kathodenraum-Vakuumaufrechterhaltung erforderlich sind.

2. Korpuskelbeschleunigende Elektrode nach Anspruch 1, dadurch gekennzeichnet, daß diese Blende (9; 10) eine Lochblende ist.

3. Korpuskelbeschleunigende Elektrode nach Anspruch 1 oder 2, dadurch gekennzeichnet, daß am Strahleingang der korpuskelbeschleunigenden Elektrode (A) ein Teil (8) mit einer elektronenoptisch geeigneten Bohrung angeordnet ist, an dessen Ende die Blende (9) zur Aufrechterhaltung des Vakuums angeordnet ist.

4. Ko·puskelbeschleunigende Elektrode nach einem der Ansprüche 1 bis 3, dadurch gekennzeichnet, daß die Öffnung der Blende (9) zur Aufrechterhaltung des Vakuums eine Abmessung von weniger als 500 μm aufweist.

5. Korpuskelbeschleunigende Elektrode nach Anspruch 4, dadurch gekennzeichnet, daß die Öffnung der Blende (9) zur Aufrechterhaltung des Vakuums eine Abmessung von weniger als 300 μm aufweist.

6. Korpuskelbeschleunigende Elektrode nach einem der Ansprüche 1 bis 5, dadurch gekennzeichnet, daß am Strahlausgang der korpuskelbeschleunigenden Elektrode (A) eine weitere Blende (10) zur Aufrechterhaltung des Vakuums und zur Strahlformung angeordnet ist.

7. Korpuskelbeschleunigende Elektrode nach Anspruch 6, dadurch gekennzeichnet, daß die weitere Blende (10) zur Aufrechterhaltung des Vakuums eine Blendenöffnung von weniger als 2 mm aufweist.

8. Korpuskelbeschleunigende Elektrode nach Anspruch 7, dadurch gekennzeichnet, daß die weitere Blende (10) zur Aufrechterhaltung des Vakuums eine Blendenöffnung von weniger als 1 mm aufweist.

9. Korpuskelbeschleunigende Elektrode nach einem der Ansprüche 1 bis 8, dadurch gekennzeichnet, daß am Strahlausgang der korpuskelbeschleunigenden Elektrode (A) ein Stutzen (2) zur Vakuum-Abdichtung und zur Justierung der korpuskelbeschleunigenden Elektrode (A) vorgesehen ist.

10. Korpuskelbeschleunigende Elektrode nach Anspruch 9, dadurch gekennzeichnet, daß auf dem Stutzen (2) ein Ring (1) angeordnet ist, dessen Abmessung flexibel an verschiedene Öffnungen von Vakuumwänden anpaßbar ist.

## Claims

1. Particle accelerating electrode (A) having a blanking system (7, 11), which is arranged within the electrode (A) constructed as a Faraday cage, for blanking a particle beam (B) coming from a source (K) arranged in a housing, characterized by at least one diaphragm which is arranged in the bead path as a part of the particle accelerating electrode (A) and the aperture of which is tapered, gradually or step by step or abruptly, to dimensions which are required for maintaining the vacuum in the cathode space.

2. Particle accelerating electrode according to Claim 1, characterized in that this diaphragm (9; 10) is a pin-hole diaphragm.

3. Particle accelerating electrode according to Claim 1 or 2, characterized in that a part (8) having an electron-optically suitable hole, at the end of which the diaphragm (9) for maintaining the vacuum is arranged, is arranged at the beam entrance of the particle accelerating electrode (A).

4. Particle accelerating electrode according to one of Claims 1 to 3, characterized in that the aperture of the diaphragm (9) for maintaining the vacuum exhibits a dimension of less than 500 μm.

5. Particle accelerating electrode according to Claim 4, characterized in that the aperture of the diaphragm (9) for maintaining the vacuum exhibits a dimension of less than 300 μm.

6. Particle accelerating electrode according to one of Claims 1 to 5, characterized in that a further diaphragm (10) for maintaining the vacuum and for beam forming is arranged at the beam exit of the particle accelerating electrode (A).

7. Particle accelerating electrode according to Claim 6, characterized in that the further diaphragm (10) for maintaining the vacuum exhibits a diaphragm aperture of less than 2 mm.

8. Particle accelerating electrode according to Claim 7, characterized in that the further diaphragm (10) for maintaining the vacuum exhibits a diaphragm aperture of less than 1 mm.

9. Particle accelerating electrode according to one of Claims 1 to 8, characterized in that a connection piece (2) for vacuum sealing and for adjusting the particle accelerating electrode (A) is provided at the beam exit of the particle accelerating electrode (A).

10. Particle accelerating electrode according to Claim 9, characterized in that a ring (1), the dimension of which can be flexibly adapted to various openings of vacuum walls, is arranged on the connection piece (2).

## Revendications

1. Electrode (A) accélératrice de corpuscules, comprenant un système de suppression (7, 11) disposé à l'intérieur de l'électrode (A), réalisée comme une cage de Faraday pour la suppression d'un faisceau corpusculaire (B) issu d'une source (K) placée dans un boîtier, caractérisée par au moins un diaphragme disposé dans la trajectoire du faisceau en tant que partie de l'électrode (A) accélératrice de corpuscules, diaphragme dont l'orifice se rétrécit progressivement, de façon échelonnée ou de manière brusque à des dimensions nécessaires au maintien du vide dans l'espace de la cathode.

2. Electrode selon la revendication 1, caractérisée en ce que le diaphragme (9; 10) est un diaphragme à orifice.

3. Electrode selon la revendication 1 ou 2, caractérisée en ce qu'une pièce (8), présentant un perçage convenant à une optique électronique, est placée à l'entrée du faisceau de l'électrode (A) accélératrice de corpuscules et que le diaphragme (9) pour le maintien du vide est disposé à l'extrémité de ce perçage.

4. Electrode selon une des revendications 1 à 3, caractérisée en ce que l'orifice du diaphragme (9) pour le maintien du vide possède une dimension inférieure à 500 μm.

5. Electrode selon la revendication 4, caractérisée en ce que l'orifice du diaphragme (9) pour le maintien du vide possède une dimension inférieure à 300 μm.

6. Electrode selon une des revendications 1 à 5, caractérisée en ce qu'un diaphragme (10) supplémentaire pour le maintien du vide et pour la conformation du faisceau, est disposé à la sortie du faisceau de l'électrode (A) accélératrice de corpuscules.

7. Electrode selon la revendication 6, caractérisée en ce que le diaphragme (10) supplémentaire pour le maintien du vide possède un orifice dont la grandeur est inférieure à 2 mm.

8. Electrode selon la revendication 7, caractérisée en ce que le diaphragme (10) supplémentaire pour le maintien du vide possède un orifice dont la grandeur est inférieure à 1 mm.

9. Electrode selon une des revendications 1 à 8, caractérisée en ce qu'une tubulure (2) pour l'étanchéité au vide et pour l'ajustement de l'électrode (A) accélératrice de corpuscules, est prévue à la sortie du faisceau de l'électrode (A).

10. Electrode selon la revendication 9, caractérisée en ce que la tubulure (2) porte une bague (1) dont la dimension est facilement adaptable à différentes ouvertures de parois d'enceintes à vide.

# FIG 1

# FIG 2